# EUROPEAN PATENT APPLICATION

(11) **EP 2 088 440 A1**
(43) Date of publication of application: **12.08.2009**
(21) Application number: 08252845.6
(22) Date of filing: 28.08.2008
(51) Int. Cl.: G01R 31/01

(54) **Monitoring of capacitor**

(30) Priority: 26.12.2007 US 964119
(71) Applicant: Pratt & Whitney Canada Corp., Longueuil, QC J4G 1A1 (CA); Hamilton Sundstrand Corporation, Windsor Locks, CT 06096-1010 (US)
(72) Inventor: Rozman, Gregory I., Rockford, IL 61114 (US); Dooley, Kevin A., Mississauga, Ontario L5C 2R6 (CA)
(74) Representative: Leckey, David Herbert

(57) **Abstract**

A capacitive element (20) is monitored to detect at least one of a degradation level, a capacitor life expectancy, and preferably servicing alarms are generated upon detection of a critical health state. The system allows, among other things, non-hermetically sealed capacitances to be safely and cost-effectively used in weight-sensitive applications, such as in aircraft electronic systems.

## Description

### TECHNICAL FIELD

The invention relates generally to capacitors and degradation monitoring systems and methods.

### BACKGROUND OF THE ART

Hermetically sealed capacitance devices are used in many applications where humidity is present since humidity has the effect of deteriorating the life expectancy of capacitors. However, such hermetically sealed capacitance devices suffer from being heavier and more costly than non-hermetically sealed capacitors.

Accordingly, there is a need to allow for the use of non-hermetically sealed capacitors in applications with high humidity degradation levels or in any other applications where the life of the capacitor is jeopardized. There is also a need to monitor capacitors while in operation.

There is also a need to monitor the operation of capacitors of all sorts, whether sealed or not, to allow the performance, life expectancy, etc., to be monitored, especially in critical applications such as aircraft electronics.

### SUMMARY

Disclosed herein is a capacitor comprising a capacitive element being non-hermetically sealed. The capacitor further comprises a sensor being integral to the capacitor and forming part of the capacitor. The sensor is for monitoring a parameter of the capacitor during operation.

Also disclosed herein is an apparatus for monitoring means for providing a capacitance. The apparatus comprises means for providing a capacitance being non-hermetically sealed; and means for sensing a parameter of the means for providing a capacitance during operation. The means for sensing being integral to the apparatus and forming part of the apparatus.

Also disclosed herein is a method for monitoring a capacitor. The method comprises providing a capacitor; sensing a parameter of the capacitor during operation; processing the measured parameter to provide a diagnosis of at least one of a capacitor degradation level and a capacitor life expectancy; and outputting the diagnosis thereby making a user aware of a health state of the capacitor.

Also disclosed herein is a capacitor device comprising a capacitor being non-hermetically sealed. The capacitor device further comprises a sensor being integral to the capacitor device and forming part of the capacitor device. The sensor for monitoring a parameter of the capacitor device during operation.

Also disclosed herein is a method of making a capacitor comprising: laying a sheet of insulating material over a first sheet of conductive material; laying a second sheet of conductive material over the sheet of insulating material thereby forming capacitive element; and rolling the capacitive element with a sensor into a cylinder to thereby form the capacitor with a sensor integrated to the capacitor.

In broad terms there is also provided an apparatus for monitoring means for providing a capacitance, the apparatus comprising: a capacitance; means for determining at least one of a degradation level and a life expectancy of the capacitance during operation; and a user interface for communicating said degradation level to a user, and an aircraft-mounted electronics system comprising: a capacitive element; at least one sensor for monitoring parameters of at least one of temperature and capacitance of the capacitive element during operation; a processor for determining a health state of the capacitive element using said parameters; and a user interface communicating with an alert system, the alert system for being triggered based on a comparison between the health state of the capacitive element determined by the processor and a threshold health state.

Further details of these and other aspects will be apparent from the detailed description and figures included below.

### BRIEF DESCRIPTION OF THE DRAWINGS

Reference is now made to the accompanying figures, in which:
Fig. 1 is a side view of layers forming a specific implementation of a capacitor configured to be monitored, with a temperature sensor;
Fig. 2 is a perspective view of the capacitor of Fig. 1 once wound into a roll and configured to be monitored with a current sensor;
Fig. 3a is a block diagram illustrating a method of using the capacitor of Fig. 2;
Fig. 3b is a block diagram illustrating another method of using the capacitor of Fig. 2;
Fig. 4 is a cross-sectional schematic view an embodiment of the capacitor of Fig. 2, with a wireless transceiver device and a remote transceiver and processing device;
Fig. 5 is the cross-sectional schematic view of the capacitor of Fig. 4, wherein the temperature and the current sensors are combined and located outside the housing; and
Fig. 6 is an isometric view of a capacitor in accordance with a specific implementation; and
Fig. 7 is an isometric view of the capacitor of Fig. 6 with a housing wall removed; and
Fig. 8 is a block diagram showing a method of making a capacitor.

### DETAILED DESCRIPTION

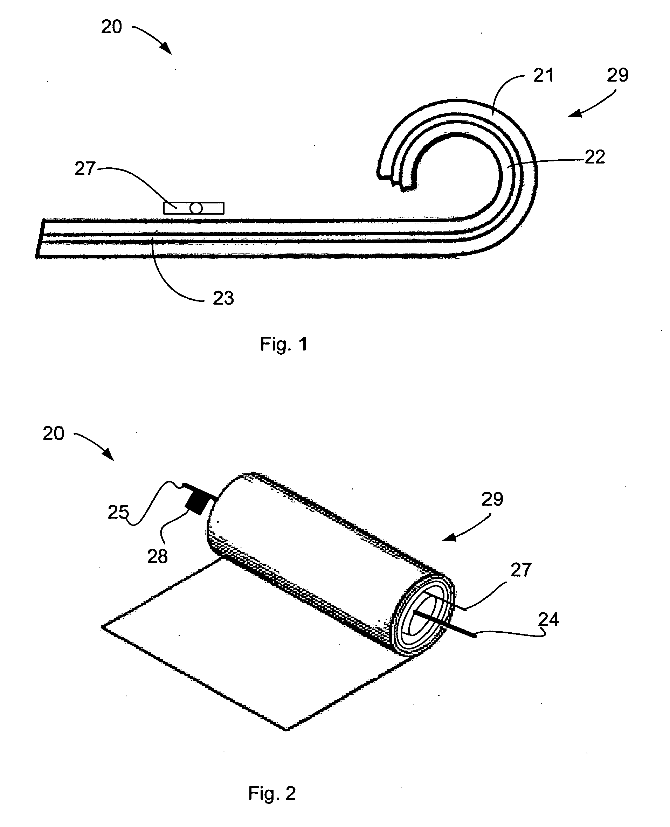

Fig. 1 is a side view of layers forming a specific implementation of a capacitor 20 configured to be monitored, as will be described further below. Dielectric capacitors described herein are made of two sheets of conductive material 21 and 22 defining a space therebetween. This space is filled with at least an insulating/dielectric material 23 such as a dielectric substance (e.g., polymer or plastic). The assembly of conductive material 21 and 22 and insulating/dielectric material 23 are referred to herein as capacitive element 29. Insulating materials can vary, and additional active materials can be used in combination with the insulating material. In electrolytic capacitors, other materials such as paper spacers soaked in electrolyte may be used. These layers are wound into a roll having any number of turns to form a cylinder which is then optionally shaped and flattened. When rolled, the sheets conductive material 21 and 22 are separated by an insulating/dielectric material 23. A temperature sensor 27 is inserted within the conductor device.

Alternatively and in other embodiments, persons skilled in the art may refer to the capacitor as a "capacitor device" and the capacitive element as a "capacitor".

Now referring to Fig. 2, the roll is treated to form connections 24 and 25, also referred to herein as terminals, at each end of the roll. The connections are made to the two sheets of conductive material 21 and 22. The sheets may be offset so that one end of the capacitor forms the first connection 24, whereas the other end forms the second connection 25. The sheets of conductive material 21 and 22 are formed by an aluminium layer or any other metallic or conductive film material, for example.

The capacitor illustrated in Figures 1 and 2 serves as an example. Those skilled in the art will understand that other types of capacitors exhibiting different characteristics, designs and overall shapes can also be used according to the present description following. The general construction remains where the two sheets of conductive material 21 and 22 described above serve as capacitor plates and with a space there between filled with a layer of insulating dielectric material.

Still referring to Fig. 2, the capacitor 20 has two connections 24 and 25 for applying a potential difference, and, according to an embodiment, a sensing device 28 for monitoring/measuring a current passing through the capacitor 20, or an operational voltage across the capacitor 20, for example. The sensing device 28 may be placed at any of the two connections 24 and 25. Sensing device 28 may be a voltage-measuring sensor, a current-measuring sensor or any other suitable sensor for monitoring/measuring a given parameter indicative of capacitor health (e.g. capacitance), as will be described further below. The sensing devices herein described are preferably placed within the capacitor 20 during manufacture.

The capacitor may be substantially enclosed in a housing, in which case the connections 24 and 25 are made to be accessible from the outside of the housing 26 such that the measurements can be read via the connections. The housing need not be hermetically sealed, as will be discussed further below.

The location of the temperature sensor 27 may be any suitable, and may differ from the illustration of Fig. 1. Other suitable configurations are possible, as long as the temperature sensor 27 can sense a temperature of the capacitor 20 during its operation and assessing, with enough precision, a health state and/or a "degradation level" of the capacitor (i.e., the amount of degradation experienced by the capacitor), as will be described further below. For example, a wire-wound temperature detector or a thin-film resistance temperature detector may be used and placed on a connection 24 or 25, around the capacitor itself, on the interior or exterior side of a housing (not shown), or anywhere suitable within the vicinity of the capacitor.

While not being restricted to the following list, sensing devices may be provided to measure capacitor internal temperature, input current, operational voltage and/or capacitance. The parameters are preferably measured as a function of time, preferably on a continuous or at least periodic basis, and during operation of the capacitor 20.

Still referring to Fig. 2, the sensing device 28 may measure a current passing through the capacitor 20 resulting from the application of a potential difference across terminals 24 and 25, or the operational voltage across the terminals 24 and 25. The sensing device 28 may be any suitable, such as, for example, a current sensor such as a giant magneto-resistive sensor (GMR), a Hall-effect sensor, or any other suitable sensor for monitoring/measuring an input current or an operational voltage resulting from a known current sent through the capacitor 20. A suitable capacitance measuring device may also/alternately be used.

Still referring to Fig. 2, a capacitance value can be determined from the measured current flowing through the capacitor 20 and the operational voltage applied across terminals 24 and 25. Alternately, a measure of a voltage resulting from a current sent into the capacitor 20 and the phase relationship between them can also be used to obtain a capacitance value in addition to the dissipation factor of the capacitor. The capacitance value and dissipation factor are monitored over time.

If the capacitor 20 is not hermetically sealed, the insulating dielectric material 23 of the capacitor 20 is susceptible to the absorption of humidity or water vapour over time. As this occurs, the dielectric constant of the material increases, which in turn increases the capacitance value of the capacitor 20. If an increase in the capacitance is detected on a capacitor in use, and the measured capacitance is determined to be over a capacitance value expected based on dry material properties, this may indicate that some degradation of the capacitor is occurring. A diagnosis of the level of capacitor degradation indicated by an increase in capacitance value may therefore be performed, and a user kept advised of the status of the capacitor degradation level, as will now be described.

Upon exposure to humidity, the conductive material 21 and 22 forming the plates of the capacitor tend to oxidize. Such oxidization forms an insulating oxide. For example, in the case of a plastic thin film coated on each side with a film of aluminium, once the plastic film absorbs water vapour, the aluminium tends to oxidize potentially due to the release of oxygen and hydrogen from the water, as a result of an electrolytic action. Some of the aluminium converts to aluminium oxide in the conductive material 21 and 22. This causes the Ohmic resistance (R) of the capacitor 20 to increase over time, leading to an increase in the power dissipation P(I) within the capacitor as a function of the current I flowing through the capacitor 20. This in turn causes the internal temperature (Tin) of the capacitor 20 to increase, which increases the dissipation factor D.

Once the dissipation factor increases, the temperature tends to further increase, ultimately resulting in total failure of the capacitor 20. The dissipation factor D is dependent on the changes in the dielectric characteristics and on the changes in the Ohmic resistance (R) of the conductive material 21 and 22 with temperature.

When AC current flows through the capacitor 20, the behaviour of the internal temperature (Tin) measured during operation is indicative of a degradation level. Hence, once the measured temperature Tin reaches a threshold level, where the efficiency/performance of the capacitor is jeopardized/degraded, this fact may be used as an indicator to generate a warning or an alert signal to indicate that investigation, servicing or replacement of the capacitor is required.

Referring to Fig. 1 and 2, the measured temperature, current and voltage applied across terminals 24 and 25 can be monitored over an operational lifetime of the component. From these measurements, values for capacitance, dissipation factor, internal resistance, power consumption and/or other related parameters, may be calculated and evaluated over time, to monitor the health of the capacitor 20. The health of the capacitor can thus be continuously monitored by periodically or continuously evaluating degradation over time.

Monitoring degradation level thus permits the use of non-hermetically or non-environmentally sealed capacitors in applications normally requiring more costly and heavier hermetically sealed capacitors. When the degradation level reaches a threshold level, the capacitor 20 of the capacitive element within the device can be changed, serviced or other appropriate servicing actions can also be taken to alleviate the effects of the degradation.

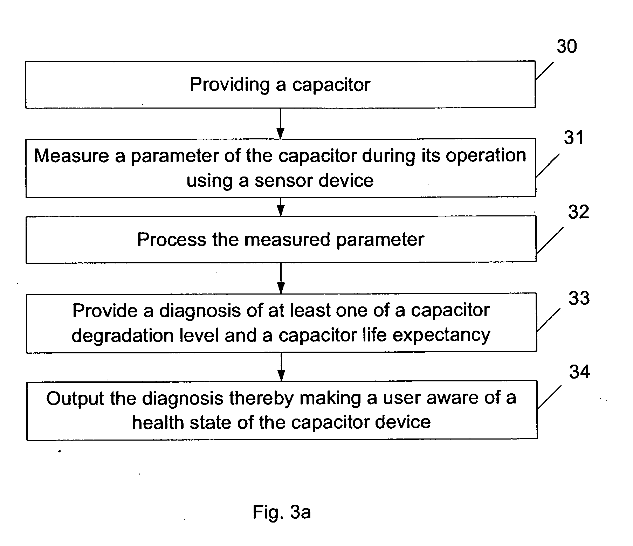

Fig. 3a is a block diagram illustrating a method for monitoring the capacitor 20.

In step 30, a capacitor is provided and a current and/or a voltage is supplied to the capacitor.

In step 31, a parameter indicative of capacitor degradation level of the capacitor during its operation is measured/sampled using a sensing device located within or with the capacitor. The sensing device senses at least a temperature of the capacitor during operation. Also, if only one of the current and voltage is supplied, the other one of the current and voltage is sensed using a sensing device.

In step 32, a measured parameter of the capacitor is calculated based on at least the sensed temperature and a supplied and/or sensed current and voltage.

The measured parameter and the sensed temperature are processed or analyzed, for example using a computer-stored look-up table or other suitable monitoring algorithm, to provide, in step 33, a diagnosis or an assessment of preferably at least one of a capacitor degradation level and a capacitor life expectancy.

Finally, in step 34, the diagnosis is output in an appropriate form, such as through a flag or alert system, to inform a user of a health state of the capacitor. A continual output may be provided, or an output may be provided only upon certain threshold condition(s) being met (e.g. a deterioration or maintenance warning, alert, etc.)

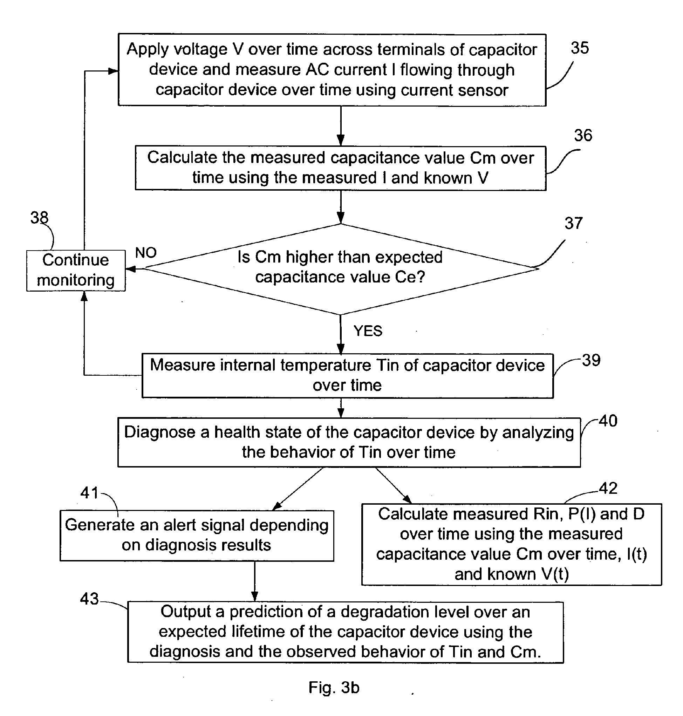

Fig. 3b illustrates another embodiment for monitoring the capacitor 20 within which capacitor degradation occurs as a result of exposure to humidity.

In step 35, a voltage versus time V(t) is applied at the terminals 24 and 25 of the capacitor 20. A resulting current I(t) is measured over time by the current sensor 28. The phase between current and voltage may also be determined.

Alternatively, in step 35, if a current I(t) is supplied at the terminals of the capacitor, a resulting voltage V(t) across the terminals 24 and 25 can be measured over time by a voltage sensor.

In step 36, a measured capacitance value Cm is calculated over time using the measured I and known V above. Alternately, the dissipation factor D may be directly calculated from the cosine of the phase angle between the voltage and current.

In step 37, it is determined whether the measured capacitance value Cm is higher than a threshold capacitance value Ce. Ce may correspond to a maximum allowable value specified by the manufacturer, or may be a warning threshold which warns that a maximum allowable value is approaching. The maximum allowable value can be set based on properties of dry materials with which the capacitor is made. Any number of thresholds may be used, as desired.

In step 38, if the capacitance value Cm is not higher than (i.e. less than or equal to) the threshold capacitance value Ce, or in other words, Cm is within a desired normal range, then monitoring continues again as from step 35.

In step 39, if Cm exceeds Ce, a temperature versus time, Tin(t), of the capacitor is measured using temperature sensor 27. Step 38 and 40 are then executed in parallel, since the capacitor is preferably monitored continuously in time, while the analysis of steps 40 and the following steps is also performed.

In step 40, a health state of the capacitor is diagnosed by analyzing the behavior of Tin over time. An increase in the behaviour of the internal temperature (Tin) over time is indicative of a degradation. For example, if Tin increases over a given threshold level during operation, the capacitor is said to have reaches a given degradation level where the efficiency/performance of the capacitor is j eopardized/degraded.

The increase in Tin may further indicate that the Ohmic resistance (R) of the capacitor 20 is increasing over time or an increase in the power dissipation P(I) within the capacitor as a function of the current I flowing through the capacitor 20.

In step 41, an alert signal or a flag may be set, depending on the diagnosis/result generated by step 40. For example, if the diagnosis of step 40 determines that one of the measured Tin, V and I and calculated parameter Cm is within a critical range or above a given threshold value, an alert signal is generated to indicate that proper actions are to be taken, or warn that a deterioration situation is approaching a certain level, etc.

Remedial actions may be proposed to the user, and may vary depending on the diagnosis results and on the parameter values themselves, according to a suitable algorithm, logic or look-up table provided. A replacement of the capacitor may be one required action, and other possible suitable actions may depend on the location, purpose and construction of the capacitor and degree or type of degradation, as the skilled reader will appreciate.

In step 42, the resistance Rin, power consumption P(I) and dissipation factor D measured over time are calculated using the measured capacitance value Cm over time, I(t) and V(t) over time as measured in step 37. From these and Tin, the dissipation factor D can be calculated as well.

In step 43, a prediction of a degradation level of the capacitor over an expected lifetime of the capacitor is determined. This prediction is performed preferably based on the diagnosis and the measured behaviour of Tin and Cm over time. The prediction is extrapolated from the general trend of the measured and calculated parameters and using a suitable statistical method.

In the above described embodiments, the measured and calculated parameters I(t) and Tin(t) are analyzed and optionally stored in a database. The calculated capacitance versus time C(t) over time, the dissipation factor over time D(t), and an internal resistance versus time Rin(t) are also optionally stored in a database for future reference. These calculated values are optionally used to provide for a history of operational parameters and degradation levels, and may also be used in providing component prognostics.

The current information can also be used as feedback information, for example, to control current across the capacitor in order to obtain, say, a sinusoidal voltage across the capacitor when used in inverter applications. The current information may also be monitored as part of an over-current protection scheme for the capacitor and/or its associated electronics. The temperature information may likewise be monitored as part of an over-temperature protection scheme for the capacitor.

The above description therefore contemplates various implementations. In the above described step 40, for example, the deterioration level can be evaluated over a time period by determining whether a significant increase in the measured capacitance value C(t), would actually leads to an increase in the internal resistance Rin(t) and the dissipation factor D(t), and if these values are at or above a given threshold, or remain within a given tolerable range.

Significant increases or other behaviours of Tin in step 40 can also be evaluated for their causes. For example, if Tin increases rapidly and follows an increase in D, then the capacitor is close to a total failure. On the other hand, if Tin increase according to a slower rate, following an increase in R and P(I), then oxidization has started but the capacitor may still be useful for a short period of operation.

An alternate embodiment may employ, in step 35, a known current I(t) passing through the capacitor, instead of a known voltage V(t) across the capacitor, and a resulting voltage V(t) is measured. Capacitance and temperature may be measured or determined in any suitable manner, and may be measured directly, or determined indirectly from other parameters. Many variants are possible, as will be appreciated by the skilled reader, and therefore need not be exhaustively listed here.

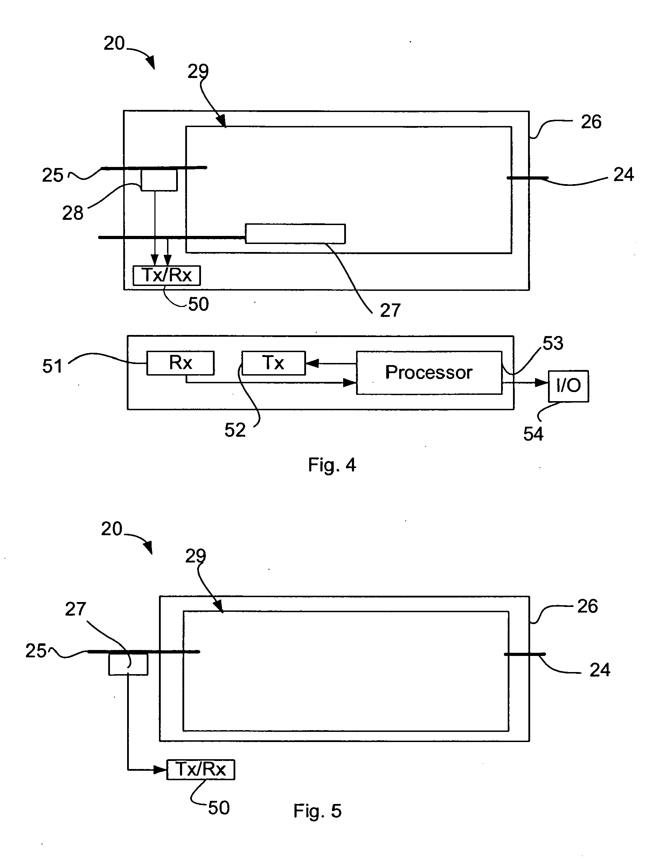

Fig. 4 is a cross-sectional schematic view of the capacitor 20 of Fig. 2, wherein the temperature sensor 27 and the current sensor 28 may communicate their respective measurements to a wireless transceiver device 50 as an alternate to being connected by wires (not shown) to the external monitoring system 53. The capacitor 20 is illustrated as having a non-hermetically sealed housing 26 around capacitive element 29. Also shown are terminals 24 and 25 providing electrical connections to capacitive element 29.

The transceiver device 50 enables the transmission of a capacitor 20 identification number or other information relative to the capacitor 20, such as technical specifications for example, as well as the parameters measured by the temperature sensor 27 and other sensing device 28 to remote receiving unit 51 Transmission may occur optionally, upon interrogation from a remote transmitter unit 52, or may be automatic upon the occurrence of an event (such as a flag or alert), or may occur continuously, or in any other suitable manner. The remote receiving and transmitting units 51 and 52 communicate with the external monitoring system/processing unit 53. Items 51 and 52 are optionally physically situated or enclosed within one transceiver unit.

The measured/calculated parameters are analyzed by the processing unit 53, such as according to the steps of Figs. 3a and/or 3b, to monitor the degradation level of the capacitor 20, as described above, and preferably generate alerts through the I/O device 54 when critical health states are diagnosed. For example, the I/O device 54 can be an output device such as a screen or a dedicated alarm device. The diagnosis results can be displayed on screen, transmitted by computer or cellular network to a maintenance base station, or handled in any other suitable manner. Other relevant information could also be displayed such that a user can, for example, visualize parametric measurements, analysis results, overall degradation levels versus time, etc. If a threshold health state is diagnosed, an alarm may be set such that a user is made aware that action is required, and the associated system also preferably indicates to the use what suitable prescribed action is required, as well as provide guidance/instructions to the service on how to accomplish it.

Fig. 5 is a cross-sectional schematic view of the capacitor 20 of Fig. 4, with sensor 27 and wireless transceiver device 50 external to housing 26. In this example, a current flowing through the capacitor 20 can be measured by using the temperature sensor 27 located externally to the housing 26. The temperature of the capacitor 20 can also be measured using the temperature sensor 27. In this embodiment, temperature sensor 27 is shown to be close to the capacitor in order to obtain more precise measurements. Also shown are terminals 24 and 25 providing connections to capacitive element 29.

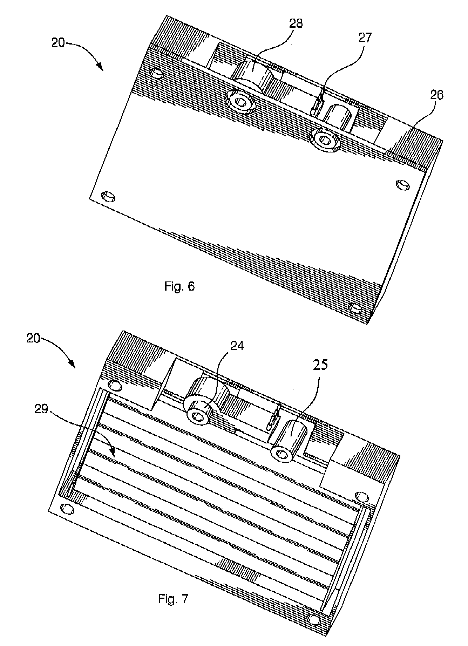

Fig. 6 is an isometric view of a capacitor 20 in accordance with a specific implementation. Temperature sensor 27 and current sensor 28 according to an embodiment are shown.

Fig. 7 is an isometric view of the capacitor 20 of Fig. 6 with a housing wall removed to reveal capacitive element 29. Also revealed are terminals 24 and 25.

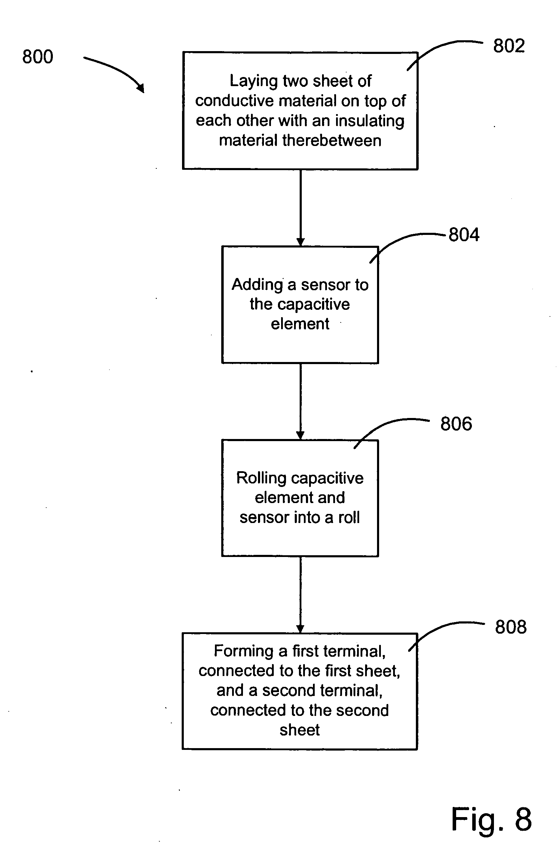

Fig. 8 is a block diagram showing a method of making a capacitor according to an embodiment of the invention. Method 800 begins with step 802, where two sheets of conductive material are laid on top of each other with a sheet of insulating/dielectric material therebetween. This assembly forms a capacitive element. In step 804, a sensor is laid on and/or attached to the capacitive element. In step 806, the capacitive element is wound (or rolled up) into a roll having any number of turns to form a cylinder. The result is a capacitor with a sensor integrated thereto. Optionally, the cylinder is shaped and flattened into a desired shape and a housing forms a non-hermetical seal around the capacitive element. In step 808, the roll is treated to form a first terminal connected to one of the sheets of conductive material at one end of the roll and a second terminal connected to the other one of the sheets of conductive material at the other end of the roll.

The above description is meant to be exemplary only and, as discussed briefly above, one skilled in the art will recognize that certain changes may be made to the above-described system and method without departing from the scope of the appended claims.

## Claims

1. A monitoring system for a capacitor, the system comprising:
a capacitive element (20);
at least one sensor (27) for monitoring parameters of at least one of temperature and capacitance of the capacitive element (20) during operation;
a processor (53) for determining a health state of the capacitive element using said parameters; and
a user interface communicating with an alert system, the alert system for being triggered based on a comparison between the health state of the capacitive element determined by the processor and a threshold health state.

2. The monitoring system of claim 1, wherein capacitance is determined using voltage and current through the capacitive element (20).

3. The monitoring system of claim 2, wherein the current through the capacitive element (20) is measured using at least one of a giant magneto resistive sensor (GMR) and a Hall-effect sensor.

4. The monitoring system of any preceding claim, wherein the sensor (27) includes a resistance temperature detector (RTD).

5. The monitoring system of any preceding claim, wherein the capacitive element (20) and the sensor (27) are disposed within a non-hermetically sealed housing (26).

6. The monitoring system of any of claims 1 to 4, wherein the capacitive element (20) is disposed within a non-hermetically sealed housing and wherein the sensor (27) is disposed outside the housing.

7. The monitoring system of any preceding claim, further comprising a transmitting device (50) for sending at least one of capacitor identification information and the parameters to the user interface.

8. The monitoring system of any preceding claim, wherein the at least one sensor (27) for monitoring parameters comprises a sensor for monitoring at least one of an ohmic resistance (R), a power consumption (P(I)) of the capacitive element and a dissipation factor (D).

9. A method for monitoring a capacitive element (20) in use, the method comprising:
supplying at least one of a current and a voltage to the capacitive element (20);
sensing a temperature of the capacitive element (20) during operation;
processing the supplied at least one of current and voltage with the sensed temperature to provide a diagnosis of at least one of a degradation level and a life expectancy of the capacitive element (20); and
outputting the diagnosis to inform a user of a health state of the capacitive element (20).

10. The method of claim 9, wherein the sensing further comprises at least one of sensing a voltage across the capacitive element (20) and sensing a current passing through the capacitive element (20).

11. The method of claim 10, further comprising calculating a capacitance value of the capacitive element (20) based on one of the supplied voltage and current and one of the sensed current and voltage.

12. The method of claim 11, further comprising outputting at least one of a capacitor identification information and at least one of the sensed temperature, the voltage, the current and the capacitance value to the user, and optionally further comprising comparing the capacitance value to an expected capacitance value, the diagnosis being based on the comparison.

13. The method as in claim 11 or 12, wherein the processing further comprises generating and outputting a predication of degradation over the life expectancy of the capacitive element based on the diagnosis, the sensed temperature and the capacitance value.

14. The method of any of claims 9 to 13, wherein the processing includes evaluating at least one of an internal resistance (R), a power consumption (P(I)) and a dissipation factor (D) of the capacitive element based on the sensed temperature, the current and the voltage.

15. The method of any of claims 9 to 14 , wherein an effect of humidity on the capacitive element is monitored based on a behaviour of the sensed temperature, and wherein the diagnosis comprises a status of a humidity-induced degradation of the capacitive element.
